# FASCICULE DE BREVET EUROPEEN

(11) **EP 2 896 074 B1**
(45) Date de publication et mention de la délivrance du brevet: **22.06.2016**
(21) Numéro de dépôt: 13792743.0
(22) Date de dépôt: 28.08.2013
(51) Int. Cl.: H01L 31/052

(54) **MODULE RECEPTEUR SOLAIRE POUR CENTRALE SOLAIRE A CONCENTRATION PHOTOVOLTAIQUE (CPV)**
SOLAREMPFÄNGERMODUL FÜR EIN KONZENTRIERTES PHOTOVOLTAISCHES KRAFTWERK
SOLAR RECEIVER MODULE FOR A CONCENTRATED PHOTOVOLTAIC (CPV) POWER PLANT

(30) Priorité: 14.09.2012 FR 1258653
(43) Date de publication de la demande: 22.07.2015
(73) Titulaire: Commissariat à l'Énergie Atomique et aux Énergies Alternatives, 75015 Paris (FR)
(72) Inventeur: MANGEANT, Christophe, F-79170 Yenne (FR); FLEURY, Gatien, F-04800 Greoux-les-Bains (FR)
(74) Mandataire: Nony
(86) Numéro de dépôt international: PCT/IB2013/058078
(87) Numéro de publication internationale: WO 2014/041454

(56) Documents cités:
- US-A1- 2003 026 536
- US-A1- 2007 070 531
- US-A1- 2010 275 998
- US-B1- 6 384 320

## Description

### Domaine technique

La présente invention concerne le domaine des récepteurs solaires pour centrale solaire à concentration photovoltaïque (CPV acronyme anglais de « *Concentrated PhotoVoltaïc »).*

La présente invention a trait plus particulièrement à la réalisation d'un nouveau module récepteur solaire pour permettre un meilleur suivi du soleil à la fois selon son angle d'azimut et de zénith par rapport à la terre afin de faire fonctionner les cellules photovoltaïques composant le module au plus près de leur maximum de production électrique.

L'invention concerne également un procédé de commande d'une centrale solaire CPV afférent.

### Art antérieur

Les systèmes fonctionnant par effet photovoltaïque qui sont connectés au réseau électrique couvrent aujourd'hui un large spectre de puissance, de quelques centaines de Watt-crête (Wc) pour des applications résidentielles à plusieurs dizaines de MWc pour les grandes centrales au sol.

Dans ces systèmes, les technologies CPV prennent une part de plus en plus prépondérante. Ces technologies CPV utilisent des optiques concentrant la lumière sur des cellules photovoltaïques. Afin d'atteindre des puissances électriques produites utilisables dans un réseau industriel, il est nécessaire de mettre en série un grand nombre de cellules photovoltaïques, ce qui permet d'obtenir une haute tension, typiquement de l'ordre de 1000 V. Le document US 6 384 320B décrit un récepteur solaire.

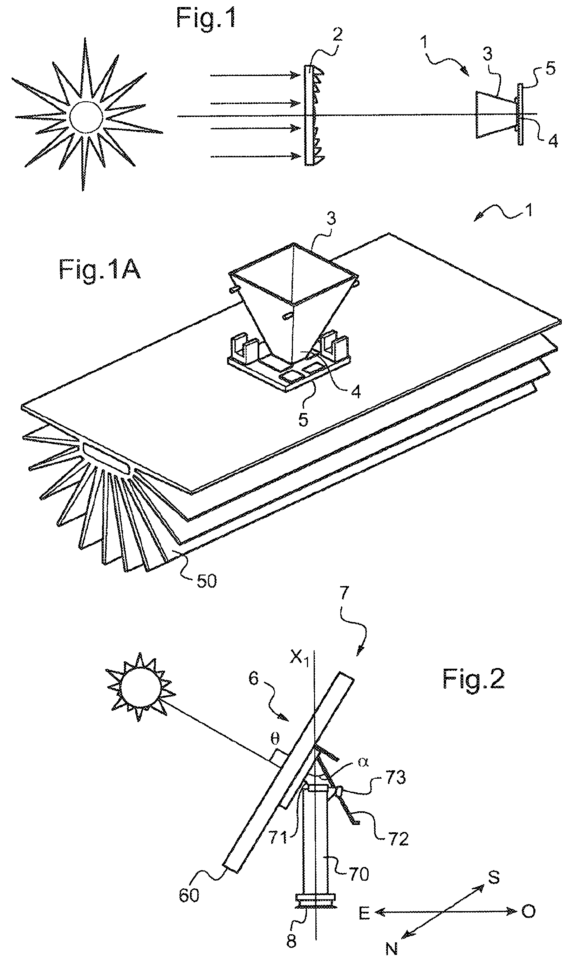

Plus précisément, un module récepteur solaire mettant en oeuvre ce type de technologies CPV comporte essentiellement quatre composants principaux, à savoir une optique primaire, une optique secondaire, une cellule photovoltaïque et un dissipateur thermique. On a représenté de manière schématique en figures 1 et 1A, un tel module récepteur 1. Il comporte respectivement de l'extérieur vers l'intérieur, une optique primaire 2 constituée par une lentille de Fresnel, une optique secondaire 3 agencée en dessous de la lentille de Fresnel, une cellule photovoltaïque 4 agencée dans la zone de concentration des rayons du soleil par la lentille de Fresnel 2 assemblée sur un récepteur 5 comportant notamment un isolant électronique, les adhésifs de cellule, une diode de bypass à fonction de sécurité et les connecteurs d'entrée-sortie et enfin, un dissipateur thermique 50 agencé en dessous du récepteur 5. L'optique secondaire 3 a une forme de tronc de pyramide droite et peut être réalisée soit en un matériau réfléchissant comme l'aluminium (massif ou sous forme de dépôt couche mince), soit en verre, la réflexion étant dans ce cas réalisée par le changement d'indice optique entre l'air et le verre. Ainsi, comme visible sur ces figures 1 et 1A, l'énergie du soleil est concentrée vers le centre de la pyramide (optique secondaire 3) par le biais de l'optique primaire 2, l'optique secondaire 3 redirigeant alors la lumière mal focalisée sur la cellule photovoltaïque 4. L'optique primaire 2 a pour fonction de concentrer les rayons du soleil orthogonaux à sa surface sur la cellule photovoltaïque 4, tandis que l'optique secondaire ne fait que récupérer une partie des photons mal focalisés par l'optique primaire 2. Autrement dit, l'optique secondaire 3 a pour fonction principale d'optimiser les performances en permettant une meilleure distribution spatiale de l'énergie incidente : elle permet d'augmenter les performances et d'homogénéiser le flux lumineux sur la cellule photovoltaïque 4. Cette dernière génère alors du courant continu par effet photovoltaïque.

Ainsi, tous les composants 2, 3, 4, 5 et 50 jouent un rôle primordial et permettent d'accroitre les performances de tels systèmes, que ce soit en termes de performances brutes (en laboratoire) qu'en termes de production énergétique (en conditions réelles de fonctionnement). Parmi les principales particularités de ces technologies CPV, on peut citer notamment :
- une forte sensibilité au spectre solaire incident due à la technologie de cellule solaire utilisée;
- une distance focale optimale entre les optiques et la cellule photovoltaïque dépendante du spectre solaire ;
- un besoin fort en dissipation thermique dû à l'utilisation d'un système de concentration de la lumière.

On distingue actuellement trois générations de cellules photovoltaïques, disponibles commercialement:
- les cellules à base de silicium Si (mono- et poly-cristallin) qui ont des rendements de photo-conversion aussi appelés rendements quantiques, i.e. des taux de conversion de l'énergie du soleil en puissance électrique, inférieurs à 25%, à cause notamment des limitations propres au matériau : en effet, le silicium présente intrinsèquement un gap qui ne permet pas de capter un spectre de photons très large ;
- les cellules formées par couches minces, en Tellure de Cadmium CdTe, à base de Cuivre, d'Indium, Gallium et Sélénium CIGS, qui ont des rendements de photo-conversion plus faibles, mais qui peuvent être produits à relativement faibles coûts ;
- les cellules à multi-jonctions, la plupart du temps à triple jonction aussi connues comme les cellules III-V, constituées de matériaux semi-conducteurs tels que Ge, InGaAs, InGaP, qui permettent d'atteindre de très hauts rendements de photo-conversion, supérieur à 40% mais qui sont onéreuses à produire.

On peut citer aussi des cellules en matériaux organiques (polymères) à très bas coût qui sont en train d'émerger, bien qu'ayant pour l'instant des rendements de photo-conversion très faibles, typiquement inférieurs à 12%.

Un des paramètres décisifs dans le choix d'une technologie de cellule photovoltaïque est le prix de revient du kilowatt-heure (kWh). Comme précisé ci-avant, bien qu'elles présentent des hauts rendements de photo-conversion, les cellules à multi-jonctions sont coûteuses.

L'utilisation de systèmes optiques à concentration permet de réduire considérablement la surface de ces cellules à multi-jonctions pour une production électrique donnée, donc de diminuer le coût de revient du kWh électrique. C'est pourquoi, les modules récepteurs solaires mettant en oeuvre la technologie CPV intègrent des systèmes optiques de concentration. Deux principaux systèmes optiques de concentration sont actuellement utilisés : ceux intégrant des lentilles de Fresnel comme montré en figure 1 ou ceux intégrant des miroirs paraboliques. Avec des surfaces de systèmes optiques de l'ordre de 500 à 2 000 cm², on peut ainsi avantageusement utiliser des surfaces unitaires de cellules à multi-jonctions de 1 à 2 cm². En d'autres termes, en pratique, on peut obtenir des facteurs de concentration de l'énergie solaire compris entre 500 et 1 500. Par exemple, des modules récepteurs solaires dits à haute concentration (HCPV, acronyme anglais de « *High Concentrated PhotoVoltaïc* »), peuvent utiliser des systèmes optiques concentrant plus de 500 fois la lumière du soleil sur des cellules à multi-jonctions de 1 cm². On précise ici, qu'usuellement, l'industrie du domaine photovoltaïque utilise le terme de haute concentration HCPV lorsque le rapport de concentration d'un module récepteur CPV est de plus de 400 fois la lumière du soleil.

Du fait de la rotation de la terre autour du soleil selon une trajectoire elliptique, il est impératif d'assurer au mieux la perpendicularité entre l'optique primaire et les rayons du soleil à toute heure de la journée et en fonction des saisons, afin d'assurer le meilleur éclairage direct des cellules, comme schématisé idéalement en figure 1. D'ailleurs, plus le facteur de concentration est important, plus l'orientation vers le soleil d'un récepteur solaire regroupant plusieurs modules récepteurs doit être précise. Typiquement, pour un facteur de concentration solaire égal à 500, on estime en général que le récepteur doit être orienté avec une précision meilleure que 1 °.

Aussi, il est nécessaire de monter les récepteurs solaires CPV sur un support orientable, appelé suiveur ou «tracker» en anglais, dont le rôle est donc d'ajuster l'orientation des modules CPV avec la trajectoire du soleil relativement à la terre, c'est-à-dire d'assurer avec une très grande précision la perpendicularité entre l'optique primaire de concentration et les rayons du soleil.

On a représenté de manière schématique en figure 2, un récepteur solaire 6 intégrant plusieurs modules CPV dans une structure support 60, usuellement appelé voile, tel qu'il est monté sur son suiveur 7 solaire dit « à deux axes ». Le suiveur 7 doit ainsi suivre la trajectoire du soleil durant toute la journée selon son angle d'azimut θ qui définit l'orientation Sud/Nord et Ouest/Est) et son angle de zénith α qui définit une position dans le ciel par rapport à l'horizontale. On précise que comme symbolisé par les flèches E, O, S, N, la direction du Sud est vers la feuille, tandis que la direction de l'Est est vers la gauche de la feuille. Le suiveur 7 comporte un support 70 central fixé à une base 8, par exemple une fondation en béton à la surface de la terre. Le récepteur solaire 6 est monté pivotant sur le support 70 autour de deux axes dont un axe de pivot 71 par le biais d'un système de vis/écrou 72, 73. Dans la position parfaite de suivi comme montré en figure 2, les optiques primaires du récepteur solaire 6 sont orientés perpendiculairement aux rayons du soleil. Pour suivre la trajectoire du soleil selon son angle d'azimut, un mécanisme d'orientation avec un actionneur est commandé pour mettre en rotation la voile 60 du récepteur 6 autour de l'axe X1 longitudinal du support central 70 du suiveur. Pour suivre la trajectoire du soleil selon son angle de zénith (angle α de la figure 2), un mécanisme d'orientation avec un actionneur est commandé pour mettre en translation la vis 72 dans son écrou 73, ce qui provoque la rotation du voile 60 autour du point de pivot 71.

Le suivi du soleil, « tracking » en anglais, c'est-à-dire la commande du déplacement du suiveur pour suivre la trajectoire du soleil à la fois selon son angle de zénith et d'azimut, se fait habituellement en mettant en oeuvre une des méthodes suivantes, qui peuvent le cas échéant être couplées entre elles:
- méthode par calculs astronomiques à partir de tables éphémérides couplés à un modèle cinématique des mécanismes d'orientation du tracker,
- méthode par calculs astronomiques couplés à un asservissement des déplacements par un ou plusieurs capteurs de type mécano-optique, tel qu'une équerre optique et/ou une caméra ;
- méthode par calculs astronomiques couplés à une vérification par un capteur photovoltaïque distinct des cellules des modules CPV, et dont on assure la collimation grâce à un dispositif collimateur dont la fonction est de s'assurer que seuls des rayons parallèles venant du soleil parviennent sur la cellule photovoltaïque.

Les demandes de brevet US 2010/0018519A1, US 2010/0018518A1 et US 2010/023138 A1 décrivent également une autre méthode selon laquelle on mesure la puissance moyenne électrique produite par un récepteur solaire CPV donné pour déterminer l'erreur de positionnement éventuelle du suiveur. Cette méthode est relativement lourde à mettre en oeuvre et nécessite un traitement statistique de la puissance électrique produite, c'est-à-dire un nombre conséquent de mesures afin de s'affranchir des aléas climatiques qui peuvent affecter les résultats de la méthode.

Le brevet US 7795568 B2 décrit aussi une autre méthode de suivi avec régulation en boucle ouverte où la position souhaitée est estimée par un modèle cinématique uniquement, et où la précision de la régulation, et donc l'alignement correct du récepteur CPV par rapport au soleil, n'est pas contrôlée. Aussi, cette méthode de suivi doit être complétée par une routine de vérification de l'alignement correct du récepteur CPV par rapport à la trajectoire du soleil.

La demande de brevet US 2010/0108860 A1 divulgue une telle routine de vérification du positionnement du récepteur CPV. Cette routine de vérification est toutefois compliquée, puisqu'elle nécessite un déplacement/une rotation physique du récepteur CPV pour la vérification en tant que telle.

Outre les inconvénients mentionnés des méthodes selon l'état de l'art qui viennent d'être décrites, la sensibilité intrinsèque à tous les capteurs de mesure utilisés et les dispersions dimensionnelles et d'assemblage éventuelles des composants d'un module CPV font que de fait les suiveurs et les méthodes de mise en oeuvre connus ne permettent pas de focaliser et/ou orienter de la manière la plus optimale possible, à tout instant de la journée et quelle que soit la saison, les rayons du soleil sur les cellules photovoltaïques d'un module récepteur solaire CPV.

Il existe donc un besoin d'améliorer le suivi de la trajectoire du soleil par un suiveur dans lequel est monté un récepteur solaire intégrant un ou plusieurs modules CPV, en vue de focaliser et/ou d'orienter de la manière la plus optimale possible les rayons du soleil sur chacun des modules CPV, à tout instant de la journée et quelle que soit la saison.

Un besoin particulier est de proposer une solution simple de mise en oeuvre et fiable d'amélioration du suivi de la trajectoire du soleil par un suiveur dans lequel est monté un récepteur solaire intégrant un ou plusieurs modules CPV.

### Exposé de l'invention

Pour ce faire, l'invention concerne, sous l'un de ses aspects, un module récepteur solaire, pour centrale solaire à concentration photovoltaïque (CPV), comportant une première optique, dite optique primaire, constituée par une lentille de Fresnel, au moins une deuxième optique, dite optique secondaire, de forme tronconique droite ou de tronc de pyramide droite, agencée en dessous de l'optique primaire, au moins une cellule photovoltaïque agencée en dessous d'une optique secondaire, pour recevoir les rayons solaires concentrés par l'optique primaire et ladite optique secondaire, le module récepteur comportant en outre des capteurs de température pour mesurer des différences de température entre une température de référence et au moins quatre points régulièrement répartis autour de l'axe reliant le centre des bases du tronc de cône ou de pyramide d'une optique secondaire afin de réaliser sa cartographie thermique.

En d'autres termes, selon l'invention, grâce aux capteurs de température, on détecte un échauffement localisé sur une partie d'une paroi comparativement à d'autres parties de parois de l'optique secondaire, cet échauffement localisé résultant d'un défaut de focalisation et/ou d'orientation du flux de rayons solaires sur l'optique secondaire.

Autrement dit, la mesure de température simultanée d'au moins quatre points régulièrement répartis sur l'optique secondaire durant un laps de temps donné permet de connaitre en temps réel et avec précision un éventuel mauvais positionnement du point de focalisation de l'optique primaire sur l'optique secondaire, le sens de déplacement de ce désalignement, et le cas échéant la partie de rayons incidents qui se retrouvent sur l'optique secondaire du fait notamment des défauts de l'optique primaire.

Grâce à la connaissance de ces deux paramètres, on peut avantageusement d'une part intervenir mécaniquement sur les réglages fins de positionnement des différents modules CPV, lors de la phase d'assemblage des modules CPV sur une voile de tracker et d'autre part, corriger le cas échéant et à tout moment de la production électrique par le récepteur CPV, toute commande de suiveur mettant en oeuvre une méthode par calculs astronomiques à partir de tables éphémérides théoriques. Ainsi, grâce à l'invention, le flux de rayons solaires peut être focalisé au mieux sur les cellules CPV des modules récepteurs solaires CPV, avec comme résultat un meilleur rendement de production électrique desdits modules.

Selon une variante préférée, les capteurs de température sont fixés chacun sur une face d'une paroi de l'optique secondaire. De préférence, les capteurs de température sont fixés chacun sur la face d'une paroi de l'optique secondaire, opposée à la face qui reçoit les rayons solaires concentrés par l'optique primaire.

Avantageusement, le module comporte un nombre de quatre capteurs de température répartis en un groupe agencé dans un plan à égale distance des bases du tronc de cône ou de pyramide de l'optique secondaire.

Selon une variante avantageuse, on peut prévoir un nombre d'au moins huit capteurs de température répartis en au moins deux groupes agencés chacun dans un plan parallèle aux bases du tronc de cône ou de pyramide de l'optique secondaire.

Selon un mode de réalisation, l'optique est de forme de tronc de pyramide droite, chaque capteur de température étant agencé sur l'axe de symétrie du trapèze formé par une des faces.

De préférence, les capteurs de température sont des thermocouples ou des sondes à variations de résistance, telles que les sondes à résistances de platine, fixés chacun par au moins un moyen de fixation en matériau conducteur thermique sur une face d'une paroi de l'optique secondaire. Le(s) moyen(s) de fixation peut (nt) être constitué(s) par un adhésif, une soudure ou une brasure. On réalise des mesures de température de manière fiable à l'aide de moyens de mesure peu coûteux.

Selon une première variante de réalisation, les optiques primaire et secondaire sont montées fixes l'une par rapport à l'autre.

Selon une deuxième variante alternative à la première variante, les optiques primaire et secondaire sont montées mobiles l'une par rapport à l'autre.

L'invention concerne sous un autre de ses aspects, un dispositif formant voile de suiveur solaire CPV comportant un support et au moins deux modules récepteurs solaires dont au moins un conforme à ce qui vient d'être décrit, montés sur un support lui-même monté pivotant autour d'au moins un axe pour suivre le soleil selon au moins un des angles parmi l'angle de zénith et d'azimut par rapport à la terre, au moins un actionneur pour faire pivoter le support autour d'au moins ledit axe.

Selon une variante de réalisation, chaque module récepteur monté sur le support est conforme à ce qui vient d'être décrit, et la voile comporte des capteurs de température afin de réaliser la cartographie thermique de deux optiques secondaires les plus éloignées l'une de l'autre dans chaque module.

Selon une autre variante alternative de réalisation, la voile comporte deux modules récepteurs montés sur le support, conformes à ce qui vient d'être décrit et comportant chacun des capteurs de température afin de réaliser la cartographie thermique de deux optiques secondaires les plus éloignées l'une de l'autre dans la voile.

Selon une variante de réalisation, le support de voile est mobile en rotation autour de deux axes distincts pour suivre le soleil à la fois selon son angle de zénith et d'azimut par rapport à la terre.

Selon une autre variante alternative de réalisation, le support de voile est pivotant autour d'un seul axe pour suivre le soleil selon un des angles parmi l'angle de zénith et d'azimut par rapport à la terre, l'autre des angles parmi l'angle de zénith et d'azimut du soleil étant suivi par déplacement de l'optique primaire par rapport à 1' (aux) optique(s) secondaire(s).

L'invention concerne sous un autre de ses aspects une centrale solaire à concentration photovoltaïque (CPV), comportant au moins une voile comme ci-avant, une unité de commande pour commander chaque actionneur.

L'invention concerne enfin, sous un autre de ses aspects, un procédé de commande de l'unité de commande d'une centrale solaire à concentration photovoltaïque qui vient d'être décrite comportant les étapes suivantes :
a/ mesure des différences de température aux quatre points d'au moins une optique secondaire;
b1/ calcul d'une première soustraction de différences de température mesurées à deux points en regard l'un de l'autre et comparaison par rapport à une valeur seuil ;
c1/ lorsque le calcul de la première soustraction est supérieur à la valeur seuil, détermination d'un premier angle de correction selon un des angles parmi l'angle de zénith et d'azimut par rapport à la terre ;
d1/ correction du pivotement du support de récepteur ou déplacement de l'optique primaire par rapport à l' (aux) optique(s) secondaire(s) en fonction du premier angle de correction ;
b2/ calcul d'une deuxième soustraction de différences de température mesurées aux deux autres points en regard l'un de l'autre et comparaison par rapport à la valeur seuil ;
c2/ lorsque le calcul de la deuxième soustraction est supérieur à la valeur seuil, détermination d'un deuxième angle de correction selon l'autre des angles parmi l'angle de zénith et d'azimut par rapport à la terre ;
d2/ correction du pivotement du support de récepteur ou déplacement de l'optique primaire par rapport à l' (aux) optique(s) secondaire(s) en fonction du deuxième angle de correction;
e/ vérification des conséquences des corrections par mesure des deux soustractions de température selon les étapes b1/ et b2/ et vérification de la baisse de température obtenue;
f/ si conséquences des corrections non effectives, alors répétition des étapes d1/ et/ou d2/ et e/, sinon répétition de l'étape a/.

De préférence, le procédé comporte une étape e'/ consistant à mesurer la puissance électrique délivrée par chaque module récepteur solaire CPV et à comparer ladite puissance mesurée avec la puissance électrique maximale apte à être délivrée par le module. Cette étape e'/ est une étape de mesure optionnelle qui consiste à vérifier avantageusement que la production électrique augmente corrélativement à la diminution de dispersion thermique.

De préférence, l'étape e/ a lieu quelques secondes après l'étape d1/ et/ou d2/. On peut ainsi réaliser les corrections quasiment en temps réel.

De préférence encore, on fait une mise à zéro des mesures selon l'étape a/ une fois par jour. Cela permet de s'affranchir du vieillissement des capteurs de température, plus particulièrement des thermocouples, c'est-à-dire de s'affranchir de toute dérive de mesures qui peut être différente entre les thermocouples.

La valeur seuil est avantageusement inférieure ou égale à 4°C, typiquement de 3 à 7°C. Cette valeur seuil correspond en pratique à la précision de capteurs de température usuels, tels que des thermocouples.

### Description détaillée

D'autres avantages et caractéristiques de l'invention ressortiront mieux à la lecture de la description détaillée d'exemples de mise en oeuvre de l'invention faite à titre illustratif et non limitatif en référence aux figures suivantes parmi lesquelles :
- la figure 1 est une vue schématique en coupe d'un module récepteur solaire CPV selon l'état de l'art illustrant l'agencement relatif de ces différents composants et par rapport au soleil ;
- la figure 1A est une vue en éclaté montrant une optique secondaire et une cellule photovoltaïque d'un module selon la figure 1 ;
- la figure 2 est une vue schématique de côté d'une voile intégrant plusieurs modules CPV et montée sur un suiveur selon l'état de l'art ;
- les figures 3A et 3B sont des vues schématiques en coupe d'une partie d'un module récepteur solaire CPV selon l'état de l'art illustrant l'agencement relatif de ces différents composants et par rapport au soleil, respectivement selon une configuration de bon et de mauvais alignement ;
- les figures 4A à 4C sont des vues schématiques de dessus d'une optique secondaire agencée au-dessus d'une cellule photovoltaïque d'un module CPV, montrant respectivement la tâche focale du soleil selon une configuration de bon alignement par rapport au soleil, de mauvais alignement selon l'angle d'azimut du soleil et de mauvais alignement selon l'angle de zénith du soleil. ;
- les figures 5A et 5B sont des vues respectivement de dessus et en perspective d'une optique secondaire d'un module CPV comportant des capteurs de température selon l'invention ;
- la figure 6 illustre les étapes d'un procédé de commande d'un module récepteur solaire CPV selon l'invention lui permettant le faire passer d'une configuration de mauvais alignement à une configuration de bon alignement ;
- les figures 7A et 7B illustrent deux variantes de réalisation différentes d'agencement des capteurs de température au sein d'un récepteur solaire intégrant plusieurs modules CPV selon un mode de réalisation de l'invention;
- la figure 8 est une en perspective d'une optique secondaire d'un module CPV comportant des capteurs de température selon une variante de l'invention.

Par souci de clarté, les mêmes références désignant les mêmes éléments d'un module récepteur solaire CPV selon l'état de l'art et d'un module récepteur solaire CPV selon l'invention sont utilisées pour toutes les figures 1 à 7B.

On précise que les différents éléments en particulier les optiques primaire et secondaire selon l'invention sont représentés uniquement par souci de clarté et qu'ils ne sont pas à l'échelle.

Les figures 1, 1A et 2 relatives à un module récepteur solaire CPV selon l'état de l'art ont déjà été commentées en préambule. Elles ne sont pas décrites ici en détail.

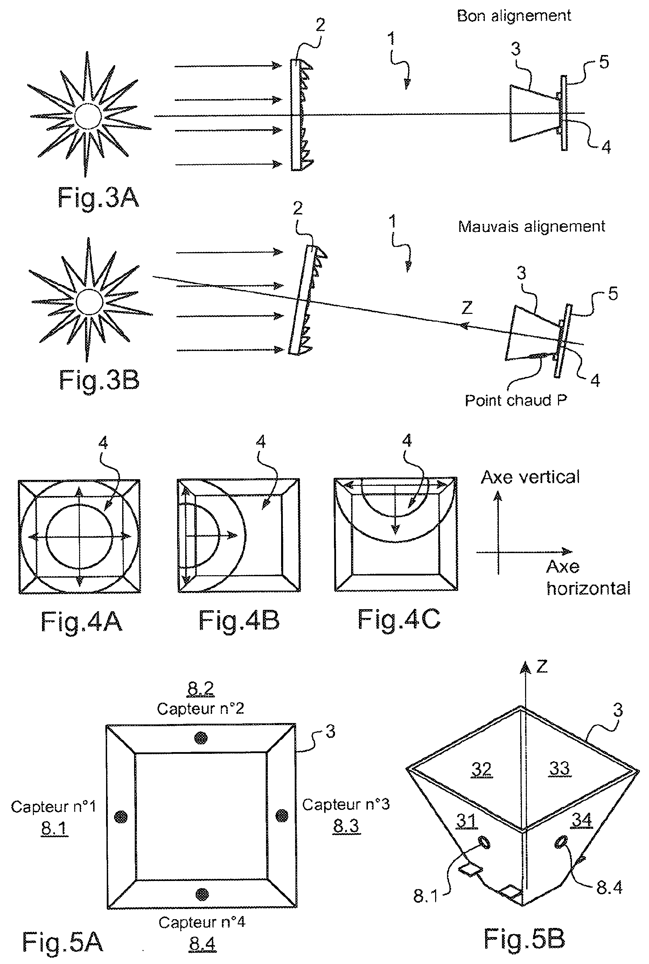

On a représenté en figure 3A une configuration d'alignement parfait d'un module 1 récepteur solaire CPV par rapport au soleil. Les rayons du soleil sont parfaitement orthogonaux à la surface de l'optique primaire 2. Les rayons sont donc parfaitement concentrés sur l'optique secondaire 3 par le biais de l'optique primaire 2, l'optique secondaire 3 dirigeant alors la lumière du soleil de manière centrée sur la cellule photovoltaïque 4. De manière schématique, la tâche focale du soleil est ainsi parfaitement centrée sur la cellule photovoltaïque 4 (figure 4A).

Or, cette configuration de bon alignement n'est quasiment jamais atteinte. Cela peut être dû à une ou plusieurs causes parmi lesquelles les inconvénients des méthodes de mises en oeuvre des suiveurs, des dispersions dimensionnelles et d'assemblage éventuelles des composants d'un module CPV, des sensibilités des capteurs de mesure utilisés dans les méthodes de suivi, de l'évolution dans le temps de l'assemblage et de ses matériaux (fluage notamment)...

Ainsi, en général, un module récepteur CPV se trouve dans une configuration de mauvais alignement par rapport au soleil. Les rayons du soleil ne sont donc pas parfaitement orthogonaux à la surface de l'optique primaire 2 et par là, ils ne sont donc pas parfaitement concentrés sur l'optique secondaire 3 (figure 3B). Autrement dit, il y a une focalisation imparfaite de l'optique primaire 2. De manière schématique, la tâche focale du soleil est ainsi décentrée par rapport au centre de la cellule photovoltaïque : en fonction de la direction du décalage de focalisation, la tâche focale est décalée sur la cellule 4. Un décalage de focalisation en azimut se traduit par exemple par une dissymétrie droite/gauche de la tâche focale sur la cellule 4 (figure 4B), tandis qu'un décalage de focalisation en zénith se traduit par une dissymétrie avant/arrière de la tâche focale sur la cellule 4 (figure 4C). Comme symbolisé schématiquement à droit des figures 4A à 4C, une dissymétrie droite/gauche est une dissymétrie selon l'axe horizontal par rapport à la surface terrestre tandis qu'une dissymétrie avant/arrière est une dissymétrie selon l'axe vertical par rapport à la surface terrestre.

Ainsi, toute dissymétrie se traduit par la création d'un point chaud P ou dit autrement par un échauffement localisé sur l'optique secondaire (figure 3B). Autrement dit, une configuration de mauvais alignement d'un module CPV par rapport au soleil, implique un gradient thermique non uniforme sur une section transversale de l'optique secondaire en forme de tronc de pyramide droite.

Pour éviter ces configurations de mauvais alignement d'un module CPV, les inventeurs ont pensé de manière judicieuse à quantifier le gradient thermique en temps réel au niveau de l'optique secondaire 3 afin de connaitre relativement précisément le positionnement du point focal de l'optique primaire 2 et son déplacement.

Ainsi, il est prévu selon l'invention de fixer quatre capteurs de température 8.1, 8.2, 8.3, 8.4 sur une face d'une paroi 31, 32, 33, 34 de l'optique secondaire 3, c'est-à-dire répartis régulièrement à 90° les uns des autres autour de l'axe Z reliant le centre des bases du tronc de la pyramide représentant l'optique secondaire.

Les capteurs de température peuvent être des thermocouples ou des sondes à variation de résistance, telles que des sondes à platine. De préférence, comme schématisé aux figures 5A et 5B, chaque thermocouple température 8.1, 8.2, 8.3, 8.4 est fixé au centre et en face arrière d'une paroi de forme trapézoïdale 31, 32, 33, 34. Cette fixation est faire à l'aide d'un adhésif en matériau conducteur thermique. Typiquement, il peut s'agir d'une pastille de kapton polyimide recouverte d'un adhésif silicone ou d'un morceau de scotch en aluminium particulièrement adapté lorsque l'optique secondaire est réalisée en aluminium. La taille et le type de pastille de collage est de préférence identique pour chaque thermocouple.

Grâce aux quatre capteurs de température 8.1, 8.2, 8.3, 8.4, il est possible de mesurer simultanément la température en ces quatre points de température durant un laps de temps donné et ainsi établir une cartographie thermique, c'est-à-dire déterminer le gradient thermique de l'optique secondaire 3. Cela permet de connaitre avec précision le positionnement du point de focalisation de l'optique primaire 2 et son déplacement.

On peut ainsi lors de la production d'électricité par un récepteur solaire intégrant plusieurs modules CPV, rectifier (affiner) la commande de déplacement d'un suiveur sur lequel est monté le récepteur par rapport à une méthode de commande par calculs astronomiques à partir de tables éphémérides.

Cette commande de rectification du déplacement du suiveur peut être faite avec asservissement en boucle fermée.

A titre de variante avantageuse, on peut envisager de fixer un nombre de huit capteurs de température répartis en deux groupes agencés chacun dans un plan parallèle aux bases du tronc de pyramide de l'optique secondaire.

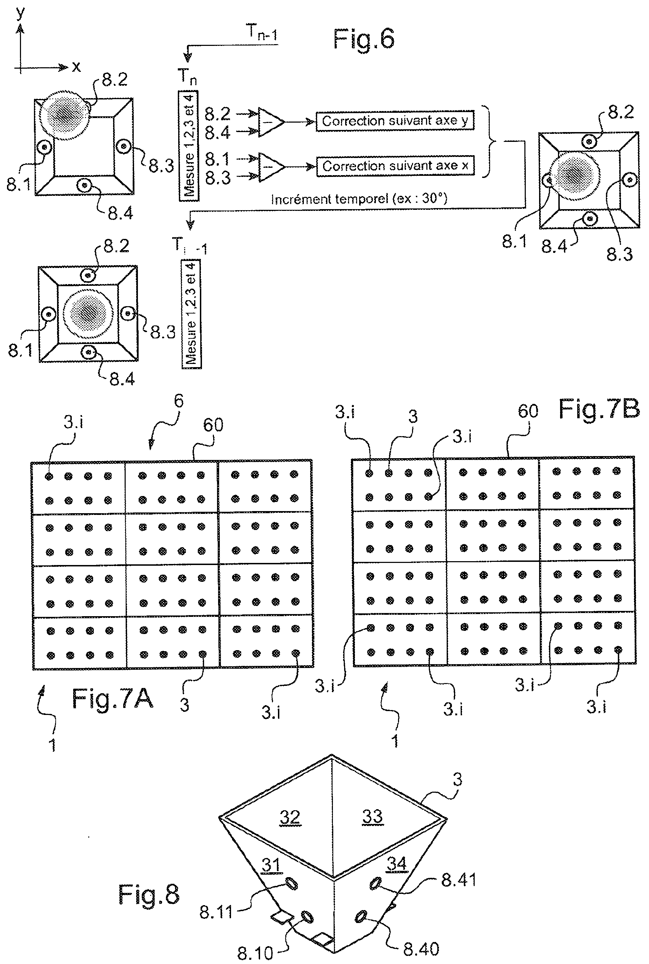

On a représenté en figure 6 les différentes étapes d'un procédé de commande de l'unité de commande d'un récepteur solaire à plusieurs modules CPV comportant des thermocouples 8.1 à 8.4 fixés sur leur optique secondaire 3 conformément à l'invention. Cette commande correspond à une rectification de déplacement du suiveur selon les deux axes x et y correspondants aux angles d'azimut et de zénith du soleil. La tâche focale est en effet représentée initialement décalée à la fois à gauche et en haut de la cellule photovoltaïque 4.
Etape a/ : mesure des différences de température simultanément grâce à chacun des quatre capteurs 8.1 à 8.4 ;
Etape b1/ : calcul d'une première soustraction de différences de température mesurées avec les deux capteurs 8.2 et 8.4 et comparaison par rapport à une valeur seuil. Typiquement la valeur seuil est égale à 4°C ;
Etape c1/ : détermination d'un premier angle de correction selon l'axe y ;
Etape d1/ : correction du pivotement du support de récepteur CPV en fonction du premier angle de correction selon l'axe y ;
Etape b2/ : calcul d'une deuxième soustraction de différences de température mesurées avec les deux autres capteurs 8.1, 8.3 et comparaison par rapport à la valeur seuil ;
Etape c2/ détermination d'un deuxième angle de correction selon l'axe x ;
Etape d2/ correction du pivotement du support de récepteur en fonction du deuxième angle de correction.

De préférence, les étapes d1/ et d2/ sont réalisées simultanément.
Etape e / : vérification des conséquences des corrections par mesure des deux soustractions de température selon les étapes b1/ et b2/ et vérification de la baisse de température obtenue.
Etape e' : vérification des conséquences des corrections par mesure de la puissance électrique délivrée par un module CPV et comparaison avec sa puissance électrique maximale.
Etape f : répétition de l'étape a/. Dans le mode de réalisation de la figure 6, on réalise un incrément temporel de l'ordre de 30s entre les étapes de corrections d1/ et d2/ et la nouvelle étape a/. Cet incrément est donné à titre indicatif dans la mesure où un incrément temporel plus important est aussi possible.

Ainsi, selon l'invention, le positionnement du point de focalisation de l'optique primaire 2 est donc lié aux soustractions réalisées selon les étapes b1/ et b2/ : on utilise la valeur absolue et le signe de ces deux soustractions dans l'unité de commande de suiveur.

Avantageusement, on peut envisager de faire une mise à zéro des mesures de température chaque jour de production électrique. Cela permet de s'affranchir de tout vieillissement des capteurs de température, tels que les thermocouples, qui peut induire une dérive de mesure différente selon les thermocouples 8.1 à 8.4.

On a représenté aux figures 7A et 7B deux variantes de réalisation distinctes d'implantation des capteurs de température conformes à l'invention au sein d'un récepteur solaire à douze modules CPV intégrés dans un même support 60, appelé voile. Les références 3.i désignent les optiques secondaires munis de capteurs de température selon l'invention tandis que les références 3 désignent des optiques secondaires connues, c'est-à-dire sans capteurs de température.

Pour un récepteur solaire CPV pour lequel les contrôles et tolérances de dimensionnement et d'assemblage sont strictement réalisés, on peut envisager l'implantation de capteurs de température afin de réaliser la cartographie thermique de deux optiques secondaires 3.i les plus éloignées l'une de l'autre dans le voile 60 du récepteur (figure 7A).

Pour obtenir un réglage fin des modules CPV après leur phase de montage sur le voile 60, et une meilleure précision de positionnement du récepteur par rapport au soleil, on peut prévoir avantageusement que chaque module 1 comporte des capteurs de température afin de réaliser la cartographie thermique de deux optiques secondaires 3.1 les plus éloignées l'une de l'autre dans chaque module (figure 7B).

L'expression « comportant un » doit être comprise comme étant synonyme de « comportant au moins un », sauf si le contraire est spécifié.

L'invention n'est pas limitée aux exemples qui viennent d'être décrits ; on peut notamment combiner entre elles des caractéristiques des exemples illustrés au sein de variantes non illustrées.

D'autres améliorations ou variantes peuvent être prévues sans pour autant sortir du cadre de l'invention.

Ainsi, on peut envisager d'implanter avantageusement un nombre de huit capteurs de température répartis en deux groupes agencés chacun dans un plan parallèle aux bases du tronc de pyramide de l'optique secondaire, comme représenté partiellement en figure 8 sur laquelle les capteurs d'un groupe 8.10, 8.40 sont agencés en dessous des capteurs 8.11, 8.41 de l'autre groupe et parallèlement aux base de l'optique secondaire 3.

L'expression « comportant un » doit être comprise comme étant synonyme de « comportant au moins un », sauf si le contraire est spécifié.

## Revendications

1. Module récepteur solaire (1), pour centrale solaire à concentration photovoltaïque (CPV), comportant une première optique (2), dite optique primaire, constituée par une lentille de Fresnel, au moins une deuxième optique (3), dite optique secondaire, de forme tronconique droite ou de tronc de pyramide droite , agencée en dessous de l'optique primaire, au moins une cellule photovoltaïque (4) agencée en dessous d'une optique secondaire, pour recevoir les rayons solaires concentrés par l'optique primaire et ladite optique secondaire, le module récepteur comportant en outre des capteurs de température (8.1, 8.2, 8.3, 8.4) pour mesurer des différences de température entre une température de référence et au moins quatre points régulièrement répartis autour de l'axe reliant le centre des bases du tronc de cône ou de pyramide d'une optique secondaire afin de réaliser sa cartographie thermique.

2. Module récepteur solaire selon la revendication 1, dans lequel les capteurs de température sont fixés chacun sur une face d'une paroi (31, 32, 33, 34) de l'optique secondaire (3).

3. Module récepteur solaire selon la revendication 2, dans lequel les capteurs de température sont fixés chacun sur la face d'une paroi de l'optique secondaire, opposée à la face qui reçoit les rayons solaires concentrés par l'optique primaire.

4. Module récepteur solaire selon la revendication 2 ou 3, comportant un nombre de quatre capteurs de température répartis en un groupe agencé dans un plan à égale distance des bases du tronc de cône ou de pyramide de l'optique secondaire (3).

5. Module récepteur solaire selon la revendication 2 ou 3, comportant un nombre d'au moins huit capteurs de température répartis en au moins deux groupes agencés chacun dans un plan parallèle aux bases du tronc de cône ou de pyramide de l'optique secondaire (3).

6. Module récepteur solaire selon l'une des revendications 4 ou 5, l'optique étant de forme de tronc de pyramide droite, chaque capteur de température étant agencé sur l'axe de symétrie du trapèze formé par une des faces.

7. Module récepteur solaire selon l'une des revendications 4 à 6, les capteurs de température étant des thermocouples ou des sondes à variations de résistance, telles que les sondes à résistances de platine, fixés chacun par au moins un moyen de fixation en matériau conducteur thermique sur une face d'une paroi de l'optique secondaire (3).

8. Dispositif formant voile de suiveur solaire CPV comportant un support et au moins deux modules récepteurs solaires dont au moins un conforme aux revendications précédentes, montés sur un support lui-même monté pivotant autour d'au moins un axe pour suivre le soleil selon au moins un des angles parmi l'angle de zénith et d'azimut par rapport à la terre, au moins un actionneur pour faire pivoter le support autour d'au moins ledit axe.

9. Voile selon la revendication 8, chaque module récepteur monté sur le support étant conforme à l'une des revendications 1 à 7 et comportant des capteurs de température afin de réaliser la cartographie thermique de deux optiques secondaires les plus éloignées l'une de l'autre dans chaque module.

10. Voile selon la revendication 8, comportant deux modules récepteurs montés sur le support, conformes à l'une des revendications 1 à 7 et comportant chacun des capteurs de température afin de réaliser la cartographie thermique de deux optiques secondaires les plus éloignées l'une de l'autre dans la voile.

11. Voile selon l'une des revendications 8 à 10 en combinaison avec la revendication 8, le support de voile étant mobile en rotation autour de deux axes distincts pour suivre le soleil à la fois selon son angle de zénith et d'azimut par rapport à la terre.

12. Voile selon l'une des revendications 8 à 10 en combinaison avec la revendication 9, le support de voile étant pivotant autour d'un seul axe pour suivre le soleil selon un des angles parmi l'angle de zénith et d'azimut par rapport à la terre, l'autre des angles parmi l'angle de zénith et d'azimut du soleil étant suivi par déplacement de l'optique primaire par rapport à l'(aux) optique(s) secondaire(s).

13. Centrale solaire à concentration photovoltaïque (CPV), comportant au moins une voile selon l'une des revendications 8 à 12, une unité de commande pour commander chaque actionneur.

14. Procédé de commande de l'unité de commande d'une centrale solaire à concentration photovoltaïque selon la revendication 13, comportant les étapes suivantes :
a/ mesure des différences de température aux quatre points (8.1, 8.2, 8.3, 8.4) d'au moins une optique secondaire (3);
b1/ calcul d'une première soustraction de différences de température mesurées à deux points en regard l'un de l'autre et comparaison par rapport à une valeur seuil ;
c1/ lorsque le calcul de la première soustraction est supérieur à la valeur seuil, détermination d'un premier angle de correction selon un des angles parmi l'angle de zénith et d'azimut par rapport à la terre ;
d1/ correction du pivotement du support de récepteur ou déplacement de l'optique primaire par rapport à l' (aux) optique(s) secondaire(s) en fonction du premier angle de correction ;
b2/ calcul d'une deuxième soustraction de différences de température mesurées aux deux autres points en regard l'un de l'autre et comparaison par rapport à la valeur seuil ;
c2/ lorsque le calcul de la deuxième soustraction est supérieur à la valeur seuil, détermination d'un deuxième angle de correction selon l'autre des angles parmi l'angle de zénith et d'azimut par rapport à la terre ;
d2/ correction du pivotement du support de récepteur ou déplacement de l'optique primaire par rapport à l' (aux) optique(s) secondaire(s) en fonction du deuxième angle de correction;
e/ vérification des conséquences des corrections par mesure des deux soustractions de température selon les étapes b1/ et b2/ et vérification de la baisse de température obtenue;
f/ si conséquences des corrections non effectives, alors répétition des étapes d1/ et/ou d2/ et e/, sinon répétition de l'étape a/.

15. Procédé de commande selon la revendication 14, comportant une étape e'/ consistant à mesurer la puissance électrique délivrée par chaque module récepteur solaire CPV et à comparer ladite puissance mesurée avec la puissance électrique maximale apte à être délivrer par le module.

## Patentansprüche

1. Solarempfängermodul (1) für ein Solarkraftwerk mit konzentrierter Photovoltaik (CPV), aufweisend eine erste Optik (2), die als primäre Optik bezeichnet wird und durch eine Fresnel-Linse gebildet wird, wenigstens eine zweite Optik (3), die als sekundäre Optik bezeichnet wird, in der Form eines geraden Kegelstumpfes oder eines geraden Pyramidenstumpfes, die unter der primären Optik angeordnet ist, wenigstens eine photovoltaische Zelle (4), die unter einer sekundären Optik angeordnet ist, um Solarstrahlung zu empfangen, die durch die primäre Optik und die genannte sekundäre Optik konzentriert wurde, wobei das Empfängermodul außerdem Temperatursensoren (8.1, 8.2, 8.3, 8.4) aufweist, zur Messung von Temperaturdifferenzen zwischen einer Referenztemperatur und wenigstens vier Punkten, die gleichmäßig um die Achse verteilt sind, die den Mittelpunkt der Basen des Kegelstumpfes oder des Pyramidenstumpfes einer sekundären Optik verbindet, um deren thermische Kartographie darzustellen.

2. Solarempfängermodul nach Anspruch 1, bei dem die Temperatursensoren jeweils an einer Oberfläche einer Wand (31, 32, 33, 34) der sekundären Optik (3) befestigt sind.

3. Solarempfängermodul nach Anspruch 2, bei dem die Temperatursensoren jeweils an einer Oberfläche einer Wand der sekundären Optik befestigt sind, die der Fläche gegenüberliegt, die die von der primären Optik konzentrierte Solarstrahlung empfängt.

4. Solarempfängermodul nach Anspruch 2 oder 3, mit vier Temperatursensoren, die in einer Gruppe verteilt sind, die in einer Ebene in gleichem Abstand zu den Basen des Kegelstumpfes oder des Pyramidenstumpfes der sekundären Optik (3) angeordnet ist.

5. Solarempfängermodul nach Anspruch 2 oder 3, mit wenigstens acht Temperatursensoren, die in wenigstens zwei Gruppen verteilt sind, die jeweils in einer Ebene parallel zu den Basen des Kegelstumpfes oder des Pyramidenstumpfes der sekundären Optik (3) angeordnet sind.

6. Solarempfängermodul nach Anspruch 4 oder 5, bei dem die Optik die Form eines geraden Pyramidenstumpfes hat, wobei jeder Temperatursensor auf der Symmetrieachse des Trapezes angeordnet ist, das durch eine der Seitenflächen gebildet wird.

7. Solarempfängermodul nach einem der Ansprüche 4 bis 6, bei dem die Temperatursensoren Thermoelemente oder Sonden mit variablem Widerstand wie etwa Widerstandsonden aus Platin sind, die jeweils mit wenigstens einem Befestigungsmittel aus einem thermisch leitfähigen Material an einer Fläche einer Wand der sekundären Optik (3) befestigt sind.

8. Vorrichtung, die ein Solar-CPV Nachlaufsegel bildet, mit einem Träger und wenigstens zwei Solarempfängermodulen, von denen wenigstens eines gemäß den vorstehenden Ansprüchen ausgebildet ist und die auf einem Träger montiert sind, der seinerseits um wenigstens eine Achse schwenkbar montiert ist, um der Sonne in wenigstens einem der Zenit- und Azimutwinkel in Bezug auf die Erde zu folgen, und wenigstens einem Antrieb zum Schwenken des Trägers um die genannte wenigstens eine Achse.

9. Segel nach Anspruch 8, bei dem jedes auf dem Träger montierte Empfängermodul nach einem der Ansprüche 1 bis 7 ausgebildet ist und die Temperatursensoren aufweist, um die thermische Kartographie der beiden sekundären Optiken darzustellen, die in jedem Modul am weitesten voneinander entfernt sind.

10. Segel nach Anspruch 8, mit zwei Empfängermodulen gemäß einem der Ansprüche 1 bis 7, die auf dem Träger montiert sind und jeweils Temperatursensoren aufweisen, um die thermische Kartographie der beiden sekundären Optiken darzustellen, die in dem Segel am weitesten voneinander entfernt sind.

11. Segel nach einem der Ansprüche 8 bis 10 in Kombination mit dem Anspruch 8, bei dem der Träger des Segels um zwei verschiedene Achsen drehbar ist, um der Sonne sowohl im Zenitwinkel als auch im Azimutwinkel in Bezug auf die Erde zu folgen.

12. Segel nach einem der Ansprüche 8 bis 10 in Kombination mit dem Anspruch 9, bei dem der Träger des Segels um eine einzige Achse schwenkbar ist, um der Sonne in einem der Zenit- und Azimutwinkel in Bezug auf die Erde zu folgen, wobei der andere der Zenit- und Azimutwinkel der Sonne verfolgt wird, indem die primäre Optik in Bezug auf die sekundäre(n) Optik(en) bewegt wird.

13. Solarkraftwerk mit konzentrierter Photovoltaik (CPV), mit wenigstens einem Segel nach einem der Ansprüche 8 bis 12 und einer Steuereinheit zur Steuerung jedes Antriebs.

14. Verfahren zur Steuerung einer Steuereinheit eines Solarkraftwerks mit konzentrierter Photovoltaik nach Anspruch 13, mit den folgenden Schritten:
a) Messen der Temperaturdifferenzen an vier Punkten (8.1, 8.2, 8.3, 8.4) wenigstens einer sekundären Optik (3);
b1) Berechnen einer ersten Subtraktion von Temperaturdifferenzen, die an zwei einander gegenüber liegenden Punkten gemessen werden, und Vergleich in Bezug auf einen Schwellenwert;
c1) wenn die Berechnung der ersten Subtraktion größer ist als der Schwellenwert, Bestimmen eines ersten Korrekturwinkels für einen der Zenit- und Azimutwinkel in Bezug auf die Erde;
d1) Korrektur der Schwenkbewegung des Trägers für den Empfänger oder der Bewegung der primären Optik in Bezug auf die sekundäre(n) Optik(en) in Abhängigkeit von dem ersten Korrekturwinkel;
b2) Berechnen einer zweiten Subtraktion der Temperaturdifferenzen, die an zwei anderen einander gegenüberliegenden Punkten gemessen werden, und Vergleich in Bezug auf einen Schwellenwert;
c2) wenn die Berechnung der zweiten Subtraktion größer ist als der Schwellenwert, Bestimmen eines zweiten Korrekturwinkels für den anderen der Zenit- und Azimutwinkel in Bezug auf die Erde;
d2) Korrektur der Schwenkbewegung des Trägers für den Empfänger oder der Bewegung der primären Optik in Bezug auf die sekundäre(n) Optik(en) in Abhängigkeit von dem zweiten Korrekturwinkel;
e) Verifizieren der Auswirkungen der Korrekturen durch Messen der beiden Subtraktionen der Temperatur gemäß den Schritten b1) und b2) und Verifizieren der erhaltenen Absenkung der Temperatur;
f) wenn die Auswirkungen der Korrekturen nicht effektiv sind, erneutes Wiederholen der Schritte d1) und/oder d2) und e), wenn nicht des Schrittes a).

15. Verfahren zur Steuerung nach Anspruch 14, mit einem Schritt e'), der darin besteht, dass die elektrische Leistung gemessen wird, die von jedem CPV Solarempfängermodul geliefert wird, und Vergleichen dieser gemessenen Leistung mit der maximalen elektrischen Leistung, die das Modul zu liefern in der Lage ist.

## Claims

1. A solar collector module (1), for a concentrated photovoltaic (CPV) solar plant, comprising a first lens (2), called the primary lens, consisting of a Fresnel lens, at least one second lens (3), called the secondary lens, that is right-frustoconical or rightfrustopyramidal shaped and arranged below the primary lens, and at least one photovoltaic cell (4) arranged below a secondary lens in order to receive the solar rays concentrated by the primary lens and said secondary lens, the collector module furthermore comprising temperature sensors (8.1, 8.2, 8.3, 8.4) for measuring temperature differences between a reference temperature and at least four points regularly distributed about the axis connecting the center of the bases of the frustocone or frustopyramid of a secondary lens in order to produce its thermal map.

2. The solar collector module as claimed in claim 1, in which the temperature sensors are each fastened to one face of one wall (31, 32, 33, 34) of the secondary lens (3).

3. The solar collector module as claimed in claim 2, in which the temperature sensors are each fastened to the face of one wall of the secondary lens, said face being opposite the face that receives the solar rays concentrated by the primary lens.

4. The solar collector module as claimed in claim 2 or 3, comprising four temperature sensors distributed in a group arranged in a plane at equal distance from the bases of the frustocone or frustopyramid of the secondary lens (3).

5. The solar collector module as claimed in claim 2 or 3, comprising at least eight temperature sensors distributed in at least two groups each arranged in a plane parallel to the bases of the frustocone or frustopyramid of the secondary lens (3).

6. The solar collector module as claimed in one of claims 4 or 5, the lens being right-frustopyramidal shaped, each temperature sensor being arranged on the axis of symmetry of the trapezoid formed by one of the faces.

7. The solar collector module as claimed in one of claims 4 to 6, the temperature sensors being thermocouples or resistance thermometer probes, such as platinum resistance probes, each of which is fastened, by at least one fastening means made of a thermally conductive material, to one face of one wall of the secondary lens (3).

8. A device forming the payload of a CPV solar tracker, comprising a supporting means and at least two solar collector modules, at least one of which is as claimed in the preceding claims, said modules being mounted on a supporting means itself pivotably mounted about at least one axis in order to track the sun in at least one of the angles chosen from its elevation and azimuth angles relative to the Earth, and at least one actuator for making the supporting means pivot about at least said axis.

9. The payload as claimed in claim 8, each collector module mounted on the supporting means being as claimed in one of claims 1 to 7 and comprising temperature sensors in order to produce the thermal map of the two secondary lenses that are furthest from each other in each module.

10. The payload as claimed in claim 8, comprising two collector modules mounted on the supporting means, said modules being as claimed in one of claims 1 to 7 and each comprising temperature sensors in order to produce the thermal map of the two secondary lenses that are furthest from each other in the payload.

11. The payload as claimed in one of claims 8 to 10 in combination with claim 9, the means supporting the payload being rotatable about two separate axes in order to track the sun both in its elevation and azimuth angles relative to the Earth.

12. The payload as claimed in one of claims 8 to 10 in combination with claim 9, the means supporting the payload pivoting about a single axis in order to track the sun in one of the angles chosen from its elevation and azimuth angles relative to the Earth, the other of the angles chosen from the elevation and azimuth angles of the sun being tracked by moving the primary lens relative to the secondary lens(es).

13. A concentrated photovoltaic (CPV) solar plant, comprising at least one payload as claimed in one of claims 8 to 12, and a control unit for controlling each actuator.

14. A method for controlling the control unit of a concentrated photovoltaic solar plant such as claimed in claim 13, comprising the following steps:
a/ measuring temperature differences at four points (8.1, 8.2, 8.3, 8.4) of at least one secondary lens (3);
b1/ calculating a first subtraction of the temperature differences measured at two points facing each other and comparing the result with a threshold value;
c1/ when the calculated first subtraction is higher than the threshold value, determining a first angular correction for one of the angles chosen from the elevation and azimuth angles relative to the Earth;
d1/ correcting the pivot angle of the means supporting the collector or moving the primary lens relative to the secondary lens(es) depending on the first angular correction;
b2/ calculating a second subtraction of the temperature differences measured at the two other points facing each other and comparing the result with the threshold value;
c2/ when the calculated second subtraction is higher than the threshold value, determining a second angular correction for the other of the angles chosen from the elevation and azimuth angles relative to the Earth;
d2/ correcting the pivot angle of the means supporting the collector or moving the primary lens relative to the secondary lens(es) depending on the second angular correction;
e/ verifying the effectiveness of the corrections by measuring two temperature subtractions according to steps b1/ and b2/ and verifying the temperature drop obtained; and
f/ if the corrections are deemed to have been ineffective, then repeating steps d1/ and/or d2/ and e/, if not repeating step a/.

15. The control method as claimed in claim 14, comprising a step e'/ consisting in measuring the electrical power delivered by each CPV solar collector module and in comparing said measured power with the maximum electrical power able to be delivered by the module.
